# EUROPEAN PATENT APPLICATION

(11) **EP 4 672 888 A1**
(43) Date of publication of application: **31.12.2025**
(21) Application number: 25180416.7
(22) Date of filing: 03.06.2025
(51) Int. Cl.: H05K 7/20

(54) **THERMAL MANAGEMENT DEVICE AND A CIRCUIT INTERRUPTER HAVING THE SAME**

(30) Priority: 07.06.2024 US 202418737039
(71) Applicant: Eaton Intelligent Power Limited, D04 Y0C2 Dublin 4 (IE)
(72) Inventor: Kittur, Vadhoot, 411028 Pune (IN); Mane, Mandar D., 415001 Maharashtra (IN); Slepian, Robert Michael, Murrysville, 15668 (US); Verma, Manoj Kumar, 412307 Maharashtra (IN)
(74) Representative: Epping - Hermann - Fischer

(57) **Abstract**

A circuit breaker includes a transient fault thermal management device including an enclosure having an inner cavity and a phase change material (PCM) disposed within the inner cavity, the transient fault thermal management device structured to provide a transient heat flow path via which heat is dissipated during a fault; a power electronic module connected between the power source and the load and structured to switch OFF to interrupt current flowing to the load during the fault; and a steady state thermal management device including a base, a body extending upward from the base, and a plurality of fins extending downward from the base, the body being attached to the power electronic module on one side and surrounded by the enclosure, the steady state thermal management device structured to provide a steady state heat flow path exclusive of the PCM and dissipate heat during a normal operation.

## Description

### FIELD OF THE INVENTION

The disclosed concept relates generally to a thermal management device for a circuit breaker, and in particular a thermal management device including phase change material (PCM) for dissipating heat during a transient high current fault.

### BACKGROUND OF THE INVENTION

Circuit interrupters, such as for example and without limitation, circuit breakers, are typically used to protect electrical circuitry from damage due to an overcurrent condition, such as an overload condition, a short circuit, or another fault condition, such as an arc fault or a ground fault. Solid state circuit interrupters use solid state components, e.g., power electronic modules including semiconductor devices, to switch on and off current flowing from a power source to a load. While the solid state devices are significantly faster than the conventional electromechanical devices, they have a much smaller thermal mass than the conventional electromechanical devices due to their compact and light configuration. Thus, the solid state devices require thermal management devices in order to promptly dissipate heat during operation. However, the temperature of power electronic modules may suddenly increase above its maximum allowed temperature during a transient high current fault (e.g., without limitation, a motor in rush current, overload faults, etc.). Such sudden increase renders the thermal management devices useless and results in damage to the power electronic modules and/or circuit breakers.

There is considerable room for improvement in thermal management device for the circuit breakers.

### SUMMARY OF THE INVENTION

These needs, and others, are met by a circuit breaker structured to be connected between a power supply and a load and to interrupt current from flowing to the load in an event of a fault. The circuit breaker includes: a power electronic module connected between the power source and the load and structured to switch OFF to interrupt current flowing to the load during the fault; a transient fault thermal management device including an enclosure having an inner cavity and a phase change material (PCM) disposed within the inner cavity, the transient fault thermal management device being structured to provide a transient heat flow path via which heat is dissipated from the power electronic module during the fault, the transient heat flow path including the PCM; and a steady state thermal management device including a base, a body extending upward from the base, and a plurality of fins extending downward from the base, the body being attached to the power electronic module on one side and surrounded by the enclosure, the steady state thermal management device being structured to provide a steady state heat flow path via which heat is dissipated from the power electronic module during a normal operation, the steady state heat flow path excluding the PCM.

Another example embodiment provides a circuit breaker structured to be connected between a power supply and a load and to interrupt current from flowing to the load in an event of a fault. The circuit breaker includes: a steady state thermal management device including a base and a plurality of fins extending downward from the base; a power electronic module disposed horizontally on top surface of the base, the power electronic module being connected between the power source and the load and structured to switch OFF to interrupt current flowing to the load during the fault; and a transient fault thermal management device including an enclosure having an inner cavity, an enclosure opening, and a phase change material (PCM) disposed within the inner cavity, the enclosure being structured to surround edges of the base of the steady state thermal management device, the enclosure opening extending upward from top surface of the enclosure, the PCM being inserted via the enclosure opening, where the steady state thermal management device provides a steady state heat flow path via which heat is dissipated from the power electronic module during a normal operation, the steady state heat flow path excluding the PCM, and where the transient fault thermal management device provides a transient heat flow path via which heat is dissipated from the power electronic module during the fault, the transient heat flow path including the PCM.

Yet another example embodiment provides a thermal management device for use in a circuit breaker including a power electronic module and structured to be connected between a power supply and a load and to interrupt current from flowing to the load in an event of fault. The thermal management device includes a transient fault thermal management device including an enclosure having an inner cavity and a phase change material (PCM) disposed within the inner cavity, the transient fault thermal management device being structured to provide a transient heat flow path via which heat is dissipated from the power electronic module during the fault, the transient heat flow path including the PCM; and a steady state thermal management device including a base and a plurality of fins extending downward from the base, the base being structured to be attached to the power electronic module and surrounded by the enclosure, the steady state thermal management device structured to provide a steady state heat flow path via which heat is dissipated from the power electronic module during a normal operation, the steady state heat flow path excluding the PCM.

### BRIEF DESCRIPTION OF THE DRAWINGS

A full understanding of the invention can be gained from the following description of the preferred embodiments when read in conjunction with the accompanying drawings in which:
Figure 1 is an interior view of a circuit interrupter having an exemplary transient fault thermal management device in accordance with an example embodiment of the disclosed concept;
Figure 2 is a back view of the circuit interrupter having the transient fault thermal management device of Figure 1;
Figure 3 is a top perspective view of the transient fault thermal management device of Figure 1;
Figure 4 is a cross-sectional view of the circuit interrupter of Figure 1 cut along the line A-A;
Figure 5 illustrates a temperature rise of a conventional thermal management device material with heat input;
Figure 6 illustrates a temperature rise of a phase change material (PCM) with heat input;
Figure 7 illustrates simulation results depicting temperature changes of a power electronic module with the transient fault thermal management device including the PCM and temperature changes of a power electronic module without the transient fault thermal management device of Figure 1;
Figure 8 illustrates an interior view of a circuit interrupter having another exemplary transient fault thermal management device in accordance with an example embodiment of the disclosed concept; and
Figure 9 illustrates an exploded view of the circuit interrupter of Figure 8.

### DETAILED DESCRIPTION OF THE INVENTION

Directional phrases used herein, such as, for example, left, right, front, back, top, bottom and derivatives thereof, relate to the orientation of the elements shown in the drawings and are not limiting upon the claims unless expressly recited therein.

As employed herein, the statement that two or more parts are "coupled" together shall mean that the parts are joined together either directly or joined through one or more intermediate parts.

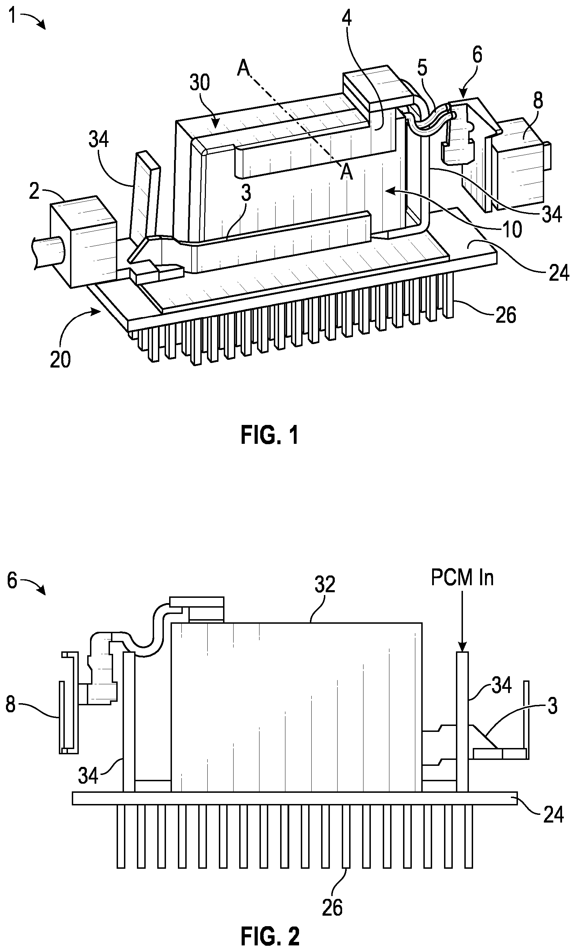

Figures 1-4 illustrate an interior view of a circuit interrupter 1 and the components thereof in accordance with an example embodiment of the disclosed concept. While Figure 1 illustrates the circuit interrupter 1 without a housing, it will be understood that this is for illustrative purposes only and that the circuit interrupter 1 and its components are disposed within the housing. The circuit interrupter 1 (e.g., without limitation, a circuit breaker) is electrically connected between a power source (e.g., utility) via a line conductor 2 and a load(s) via a load conductor 8. The circuit breaker 1 is structured to trip or switch open to interrupt current flowing to the load, for example, in the case of a fault condition (e.g., without limitation, an overcurrent condition) to protect the load, circuitry associated with the load, as well as the components within the circuit breaker 1. The circuit breaker 1 may be a single-phase circuit breaker or any other number of phases may be employed without departing from the scope of the disclosed concept.

The circuit breaker 1 includes a power electronic module 10, a steady state thermal management device 20 and a transient fault thermal management device 30. The circuit breaker 1 may also include a sensor (e.g., without limitation, current sensor, temperature sensor, etc.), a control circuit (e.g., a microcontroller, a CPU, etc.) and a power supply circuit for supplying power to the electrical components within the circuit breaker 1. The power electronic module 10 is connected to the line conductor 2 via a busbar 3 and to a flexible thermal strip 5 via a busbar 4. The flexible thermal strip 5 is connected to the separable contacts 6, which in turn are connected to the load conductor 8 and to the load (not shown). The separable contacts 6 provide galvanic isolation when a mechanical switch of the circuit interrupter 1 is toggled. The power electronic module 10 may include, e.g., without limitation, a solid state switching elements (e.g., without limitation, metal-oxide-semiconductor-field-effect-transistors (MOSFETs), insulated-gate bipolar transistors (IGBTs)). The solid state switching elements are structured to turn on and off (i.e., open and close) to allow or interrupt current flowing to the load. The power electronic module 10 may extend vertically upward relative to the steady state thermal management device 20.

The steady state thermal management device 20 is a heat sink structured to draw heat away from the power electronic module 10 and dissipate the heat into the ambient and/or a coolant. It may be made of, e.g., without limitation, aluminum and includes a body 22, a base 24 and a plurality of fins 26. The body 22 may include, e.g., without limitation, an aluminum block extending vertically upward from the base 24. The body 22 is structured to be attached to the power electronic module 10 on one side 23 and support the power electronic module 10. The fins 26 extend vertically downward from the base 24 and are structured to provide more surface area to dissipate the heat. The fins 26 may include a coolant. During the normal operation, the steady state thermal management device 20 provides a steady state heat flow path 37 from the power electronic module 10 to the body 22 of the steady state thermal management device 20, to the base 24 and to the ambient or coolant (the power electronic module 20 → the body 22 of the steady state thermal management device 20 → the base 24 of the steady state thermal management device 20 → the ambient or coolant).

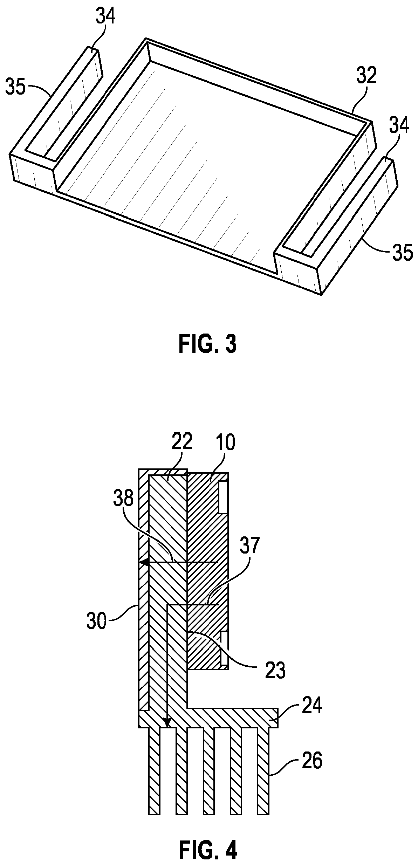

The transient fault thermal management device 30 is structured to provide a transient heat flow path 38 (see Figure 4) during transient power peaks (e.g., without limitation, a motor in rush current, overload faults, etc.). It includes an enclosure 32 and one or more legs 35. The enclosure 32 is made of plastics, e.g., without limitation, thermoset. The enclosure 32 has an inner cavity structured to receive a PCM via the one or more enclosure openings 34 during manufacturing or use. A PCM is a substance that absorbs or releases a significant amount of energy in the form of latent heat when it changes phase (e.g., without limitation, from solid to liquid). The enclosure 32 is structured to surround the body 22 of the thermal management device 20 except for the one side 23. The one or more legs 35 extend upward from one or more bottom edges of the enclosure 32. Each leg 35 may include an enclosure opening 34 via which the PCM is received or refilled into the inner cavity. The one or more legs 35 and the enclosure 32 are separated to form a space therebetween so as to allow sufficient spacing for expansion of the body 22 of the steady state thermal management device 20 when heat is input. By including the PCM within the enclosure 32 and attaching the transient fault thermal management device 30 to the steady state thermal management device 20 on the side opposite to the one side 23 to which the power electronic module 10 is attached, the PCM creates the transient heat flow path 38 (the power electronic module 10 → the body 22 of the steady state thermal management device 20 → the enclosure 32 of the transient fault thermal management device 30 → the ambient or coolant) via which the heat flows and dissipates during transient high current faults.

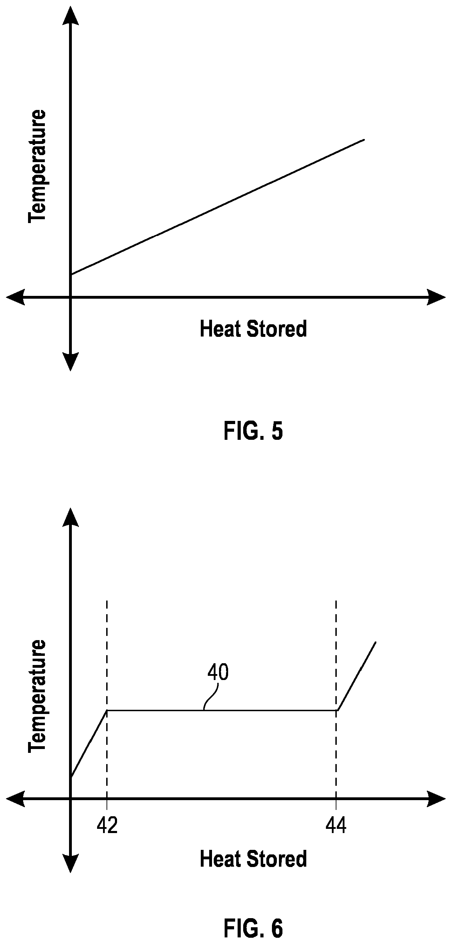

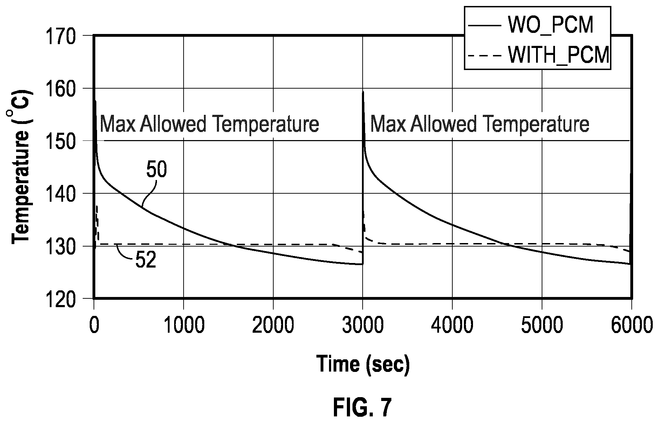

In other words, the transient fault thermal management device 30 utilizes the latent heat capacity of the PCM to maintain the temperature of the power electronic module 10 within the maximum allowed temperature during transient high current faults. As shown in Figure 6, upon reaching its melting temperature at 42, the PCM undergoes a phase change process 40. The PCM starts to melt and stores the heat in the latent form with little or no temperature rise. The temperature rises only upon completion of the phase change at 44. Thus, by selecting the PCM with a melting temperature below the maximum allowed temperature of the power electronic module 20, the PCM ensures that the temperature of the power electronic module 20 is maintained below the maximum allowed temperature of the power electronic module 20 as it changes phase during a transient high current fault. Such latent heat capacity is not present in the conventional heat sink thermal conductor materials (e.g., without limitation, aluminum), which store heat in sensible form, resulting in a steady temperature rise with increasing heat as shown in Figure 5. The difference in temperature rises of the conventional heat sink thermal conductor materials and the PCM is discussed further in detail with reference to Figure 7.

Further, the heat will flow through the PCM via the transient heat flow path 38 only during the transient peak powers, and thus PCM has little or no impact on the maximum temperature of the power electronic module 10 during the normal operation. That is, the addition of the PCM within the enclosure 32 does not increase thermal resistance in the steady state heat flow path 37, and thus the maximum temperature during the normal operation is not affected by the PCM. This is advantageous over the existing PCM thermal management devices that include the PCM in series with a heat sink such that the heat is required to flow through the PCM to reach the heat sink. Such heat flow path requiring the heat to flow through the PCM in series with the heat sink increases thermal resistance and maximum temperature of the power electronic module during the normal operation.

Moreover, by adding the PCM within the inner cavity of the enclosure 32, not within the steady state thermal management device 20, the transient fault thermal management device 30 ensures that no negative impact on the thermal and structural performance of the steady state thermal management device 20 occurs. For example, some existing heat sinks include the PCM within their fins. This prevents the air or coolant from flowing through the fins, and thus precludes free or forced convection from occurring, thereby rendering the heat sink ineffective. In addition, volumetric changes in the PCM cause stresses on the fins, rendering the heat sink prone to failure. Furthermore, the melted PCM may resolidify within the enclosure 32 during the steady state operation, and therefore does not require a continuous flow or circulation of solder. The solder can be replaced through the enclosure opening 34 if needed.

Figure 7 illustrates simulation results depicting temperature changes 52 of a power electronic module with the transient fault thermal management device and temperature changes 50 of the power electronic module without the transient fault thermal management device of Figures 1-4. For simulation, the boundary conditions for the transient fault thermal management device 30 were defined to specify heat loss from the power electronic module 10 as a heat flux, melting and solidification model for phase change, and heat transfer coefficient applied to the steady state thermal management device 20 in order to simulate forced convection. The melting and solidification model utilizes enthalpy property to simulate phase change process. During the steady state, the heat flows from the power electronic module 10 directly to the steady state thermal management device 20 and to the ambient or coolant in a steady state heat flow path 37 (see Figure 4). During a transient power peak, the PCM reaches its melting point and starts to melt and absorbs the latent heat at a constant temperature (e.g., without limitation, 130°C). Figure 7 shows the power electronic module 10 reaching peak power at time zero, 3000s and at 6000s. As the PCM absorbs the peak power, it starts to melt and absorbs heat in the latent form, maintaining the temperature of the power electronic module 10 close to the melting temperature of, e.g., without limitation, 130°C. The temperature 50 of the power electronic module used with a heat sink having conventional thermal conductor materials rises above the maximum allowed temperature (e.g., without limitation, 150°C) during each peak power, thereby damaging the power electronic module. Whereas, the temperature 52 of the power electronic module 10 used with the inventive transient fault thermal management device 30 remains below the maximum allowed temperature during the peak power, thereby protecting the power electronic module 10 from effects of the sudden power spikes.

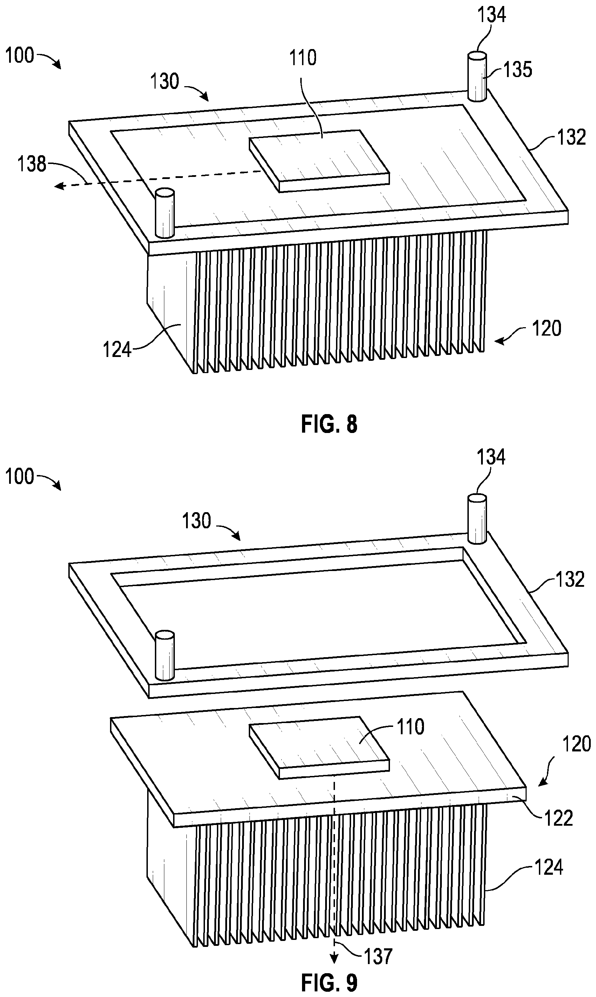

Figures 8 and 9 illustrate an interior view of an exemplary circuit breaker 100 having a transient fault thermal management device 130 in accordance with a non-limiting, example embodiment of the disclosed concept. The circuit breaker 100 is similar to the circuit breaker 1 of Figures 1-4 except for the structure and/or disposition of the power electronic module 110, the steady state thermal management device 120 and the transient fault thermal management device 130. Thus, overlapping description of similar features and components is omitted for sake of brevity. Unlike the steady state thermal management device 20, the steady state thermal management device 120 does not include a body portion that extends vertically upward from the base 122 and supports the power electronic module 110. As such, the power electronic module 110 is disposed horizontally flat on the top surface of the base 122 of the steady state thermal management device 120. Further, the transient thermal management device 130 includes one or more legs 135 extending upward from top surface of the enclosure 132. Each leg 135 includes an enclosure opening 134. In addition, the enclosure 132 has a shape of a frame structured to surround the outer edges of the base 122 of the steady state thermal management device 120. During the steady state, the steady state thermal management device 120 provides a steady state heat flow path 137 directly from the power electronic module 110 to the ambient via the fins 124. During the transient power peak, the transient fault thermal management device 130 provides an alternate heat flow path 138 from the power electronic module 110 to the ambient through the base 122 of the steady state thermal management device 120 and the PCM. The structures and configurations of the power electronic module 110, the steady state thermal management device 120 and the transient fault thermal management device 130 of Figures 8-9 are for illustrative purposes only, and thus may be adjusted or altered so as to fit the interior design and spaces available within the circuit breakers.

While specific embodiments of the invention have been described in detail, it will be appreciated by those skilled in the art that various modifications and alternatives to those details could be developed in light of the overall teachings of the disclosure. Accordingly, the particular arrangements disclosed are meant to be illustrative only and not limiting as to the scope of disclosed concept which is to be given the full breadth of the claims appended and any and all equivalents thereof.

## Claims

1. A circuit breaker structured to be connected between a power supply and a load and to interrupt current from flowing to the load in an event of a fault, the circuit breaker comprising:
a power electronic module connected between the power source and the load and structured to switch OFF to interrupt current flowing to the load during the fault;
a transient fault thermal management device including an enclosure having an inner cavity and a phase change material, PCM, disposed within the inner cavity, the transient fault thermal management device being structured to provide a transient heat flow path via which heat is dissipated from the power electronic module during the fault, the transient heat flow path including the PCM; and
a steady state thermal management device including a base, a body extending upward from the base, and a plurality of fins extending downward from the base, the body being attached to the power electronic module on one side and surrounded by the enclosure, the steady state thermal management device being structured to provide a steady state heat flow path via which heat is dissipated from the power electronic module during a normal operation, the steady state heat flow path excluding the PCM.

2. The circuit breaker of claim 1, wherein upon reaching a melting temperature, the PCM starts to melt and absorb heat in a latent form at a constant temperature and creates the transient heat flow path.

3. The circuit breaker of claim 2, wherein latent heat capacity of the PCM allows the PCM to resist a change in temperature during the fault and provides a lower peak temperature as compared to a peak temperature obtained by a thermal management device without a PCM.

4. The circuit breaker of claim 2 or 3, wherein the constant temperature is below a maximum allowed temperature of the power electronic module.

5. The circuit breaker of one of claims 1 to 4, wherein the PCM does not affect a maximum temperature of the power electronic module during the normal operation.

6. The circuit breaker of claim 5, wherein the heat flows through the PCM only during the fault.

7. The circuit breaker of claim 5 or 6, wherein the PCM does not increase thermal resistance in the steady state heat flow path during the normal operation.

8. The circuit breaker of one of claims 1 to 7, wherein the PCM is selected to have melting temperature below a maximum allowed temperature of the power electronic module so as to maintain the temperature of the power electronic module within the maximum allowed temperature as the PCM melts during the fault.

9. The circuit breaker of one of claims 1 to 8, wherein the transient fault thermal management device further includes one or more legs extending upward from one or more bottom edges of the enclosure, each leg having an enclosure opening via which the PCM is received into the inner cavity, and wherein the enclosure is structured to envelope the body of the steady state thermal management device except for the one side, and wherein the one or more legs and the enclosure are separated to form a space therebetween so as to allow the body of the steady state thermal management device to expand when heat is input.

10. The circuit breaker of one of claims 1 to 9, wherein the fins of the steady state thermal management device do not include PCM.

11. A circuit breaker structured to be connected between a power supply and a load and to interrupt current from flowing to the load in an event of fault, the circuit breaker comprising:
a steady state thermal management device including a base and a plurality of fins extending downward from the base;
a power electronic module disposed horizontally on top surface of the base, the power electronic module being connected between the power source and the load and structured to switch OFF to interrupt current flowing to the load during the fault; and
a transient fault thermal management device including an enclosure having an inner cavity, an enclosure opening, and a phase change material (PCM) disposed within the inner cavity, the enclosure being structured to surround edges of the base of the steady state thermal management device, the enclosure opening extending upward from top surface of the enclosure, the PCM being inserted via the enclosure opening,
wherein the steady state thermal management device provides a steady state heat flow path via which heat is dissipated from the power electronic module during a normal operation, the steady state heat flow path excluding the PCM, and
wherein the transient fault thermal management device provides a transient heat flow path via which heat is dissipated from the power electronic module during the fault, the transient heat flow path including the PCM.

12. The circuit breaker of claim 11, wherein upon reaching a melting temperature, the PCM starts to melt and absorb heat in a latent form at a constant temperature and creates the transient heat flow path, wherein latent heat capacity of the PCM allows the PCM to resist a change in temperature during the fault and provides a lower peak temperature as compared to a peak temperature obtained by a thermal management device without a PCM, and wherein the constant temperature is below a maximum allowed temperature of the power electronic module.

13. The circuit breaker of claim 11 or 12, wherein the PCM does not affect a maximum temperature of the power electronic module during the normal operation.

14. The circuit breaker of claim 13, wherein the heat flows through the PCM only during the fault, and wherein the PCM does not increase thermal resistance in the steady state heat flow path during the normal operation.

15. A thermal management device for use in a circuit breaker including a power electronic module and structured to be connected between a power supply and a load and to interrupt current from flowing to the load in an event of fault, the thermal management device comprising:
a transient fault thermal management device including an enclosure having an inner cavity and a phase change material (PCM) disposed within the inner cavity, the transient fault thermal management device being structured to provide a transient heat flow path via which heat is dissipated from the power electronic module during the fault, the transient heat flow path including the PCM; and
a steady state thermal management device including a base and a plurality of fins extending downward from the base, the base being structured to be attached to the power electronic module and surrounded by the enclosure, the steady state thermal management device structured to provide a steady state heat flow path via which heat is dissipated from the power electronic module during a normal operation, the steady state heat flow path excluding the PCM.
